# EUROPÄISCHE PATENTSCHRIFT

(11) **EP 2 997 213 B1**
(45) Veröffentlichungstag und Bekanntmachung des Hinweises auf die Patenterteilung: **27.05.2020**
(21) Anmeldenummer: 14723769.7
(22) Anmeldetag: 09.05.2014
(51) Int. Cl.: E05F 15/611, E05D 15/46, H03K 17/96, H03K 17/965, A47B 88/457

(54) **BEHÄLTNIS UND VERFAHREN ZUM AUSLÖSEN EINER ANTRIEBSVORRICHTUNG DES BEHÄLTNISSES**
RECEPTACLE AND PROCES FOR ACTIVATING A DRIVING DEVICE OF THE RECEPTACLE
RÉCIPIENT ET PROCÉDÉ POUR DÉCLENCHER UN ACTIONNEUR DU RÉCIPIENT

(30) Priorität: 11.05.2013 DE 102013104866
(43) Veröffentlichungstag der Anmeldung: 23.03.2016
(60) Teilanmeldung: 16204025.7
(73) Patentinhaber: KESSEBÖHMER HOLDING KG, 49152 Bad Essen (DE)
(72) Erfinder: BARKAU, René, 49179 Ostercappeln (DE)
(74) Vertreter: Neumann Müller Oberwalleney & Partner Patentanwälte
(86) Internationale Anmeldenummer: PCT/EP2014/059535
(87) Internationale Veröffentlichungsnummer: WO 2014/184103

(56) Entgegenhaltungen:
- WO-A1-2008/141358
- WO-A2-02/37516
- WO-A2-2008/141348
- DE-U1-202005 018 353

## Beschreibung

Die Erfindung betrifft ein Behältnis nach dem Oberbegriff des Anspruchs 1.

Ein Möbel der eingangs genannten Art ist aus der WO 2008/141348 A2 bekannt. Das Möbel weist ein erstes Element in Form eines Möbelkorpus und ein zweites Element in Form einer bewegbaren Klappe auf. Mittels der Antriebsvorrichtung kann die Klappe automatisch in eine Offen- und in eine Schließlage überführt werden. Zum Betätigen, d.h. zum Einschalten der Antriebsvorrichtung, ist ein Schaltelement vorgesehen. Das Schaltelement ist derart angeordnet und ausgebildet, dass durch eine vom Benutzer verursachte Bewegung der Klappe die Antriebsvorrichtung ausgelöst wird. Hierbei ist die Klappe in ihrer Schließlage derart angeordnet, dass es das Schaltelement überdeckt und an diesem anliegt. Durch Druckausübung auf die Klappe in Richtung zum Möbelkorpus wird ein Druckschalter des Schaltelements geschaltet und die Antriebsvorrichtung ausgelöst. Hierbei ist ein genügend großer Einrückweg für den Druckschalter und damit für die Klappe vorzusehen, der zwischen der Klappe und dem Möbelkorpus vorhanden sein muss. Dies kann zum Beispiel durch einen Federpuffer sichergestellt werden. Nachteilig kann sich auswirken, dass bei jedem Druck auf die Klappe die Antriebsvorrichtung ausgelöst wird und die Klappe in die Öffnungslage überführt, selbst wenn die Klappe unbeabsichtigt eingerückt wurde. Alternativ schlägt WO 2008/141348 A2 vor, eine Positionsmesseinrichtung vorzusehen, mittels der auch die Geschwindigkeit und Beschleunigung der Bewegung der Klappe berechnet werden kann. Dies gestattet es, das Antreiben der Klappe durch die Antriebsvorrichtung in Abhängigkeit der erfassten Größen der Klappe vorzunehmen. Auch hier ist ein entsprechender Einrückweg über Federpuffer vorzusehen. Eine weitere Alternative, die in der WO 2008/141348 A2 vorgeschlagen wird, sind kapazitive Schaltelemente, die berührungslos arbeiten.

Aufgabe der vorliegenden Erfindung ist es, ein Behältnis der eingangs genannten Art bereitzustellen, bei dem es ermöglicht wird, dass zum Auslösen der Antriebsvorrichtung ein möglichst geringer, vorzugsweise für den Benutzer nicht spürbarer, Weg zum Betätigen einer Betätigungsvorrichtung realisierbar ist.

Die Aufgabe wird erfindungsgemäß durch ein Behältnis nach Anspruch 1 gelöst.

Ein Verformungssensor weist mehrere Vorteile gegenüber herkömmlich eingesetzten Schaltelementen auf. Der Verformungssensor nimmt die Verformung eines Bauteils auf und gibt sie als Verformungssignal ab, wobei der Verlauf der Verformungsänderung abgelesen werden kann. Das bedeutet, dass nicht ein digitales Signal abgegeben wird, wie dies bei einem Schaltelement der Fall ist, sondern ein analoger Verlauf einer Verformung bzw. einer Verformungsänderung als Verformungssignal zur Verfügung steht. Mit dem Begriff "analog" ist nicht gemeint, dass das Verformungssignal nicht digital abgetastet und als digitales Signal weitergeleitet werden kann. Vielmehr ist damit gemeint, dass nicht nur zwei Zustände einer Messgröße, wie dies bei einem Schaltsignal (Ein/Aus) der Fall ist, gemessen werden können, sondern ein analoges Signal oder ein digital erfasstes Signal eines Verlaufs einer Messgröße mit einer Genauigkeit je nach digitaler Auflösung.

Dies hat den Vorteil, dass Einbautoleranzen der beiden Elemente zueinander und der Verformungsmesseinheit keinen Einfluss darauf haben, wann die Antriebsvorrichtung betätigt wird. Herkömmlich verwendete Schaltelemente weisen einen präzisen Schaltpunkt auf, bei dessen Erreichen bzw. Überschreiten der Schalter von einem Zustand in einen anderen Zustand umgeschaltet wird. Damit ist klar vorgegeben, bei welcher Position des Schaltelements die Antriebsvorrichtung betätigt wird. Die Lage dieses Schaltpunkts ist von den Einbautoleranzen abhängig. Insbesondere dann, wenn die Antriebsvorrichtung durch eine Kraftausübung auf ein Element des Behältnisses ausgelöst wird, also das Schaltelement indirekt, z.B. über eine Klappe des Behältnisses, geschaltet wird, ist somit der Schaltpunkt durch die Einbautoleranzen vorgegeben. Bei der Verwendung eines Verformungssensors ist dies nicht der Fall. Hier muss lediglich eine anfängliche Initialisierung stattfinden, so dass die Steuereinheit derart angelernt wird, dass sie bei gegebenen Einbauverhältnissen das in der Schließstellung anliegende Verformungssignal als Referenz vorliegen hat und ausgehend von diesem Referenzwert relative Verformungsänderungen verarbeiten kann.

Die Verformungsmesseinheit weist ein Aufnahmeelement auf, in dem der Verformungssensor aufgenommen ist, wobei das Aufnahmeelement im oder an dem ersten Element befestigt ist. Hierbei ist das zweite Element gegen den Verformungssensor abgestützt.

Darüber hinaus ist in dem Aufnahmeelement ein zusätzlicher Schalter zum Betätigen der Antriebsvorrichtung integriert. Dies ist insbesondere dann von Vorteil, wenn es sich bei dem Behältnis um einen Oberschrank mit einer nach oben bewegenden Klappe handelt. Durch Druckausübung auf die in der Schließstellung befindliche Klappe kann, wie oben beschrieben, die Antriebsvorrichtung betätigt werden, da sich die Klappe über die Verformungsmesseinheit gegen den Korpus abstützt. Sobald sich die Klappe in der Offenstellung befindet, ist eine weitere Vorrichtung vorzusehen, um die Klappe wieder zurück in die Schließstellung zu bewegen. Dies wird durch den Schalter realisiert, der in dem Aufnahmeelement der Verformungsmesseinheit angeordnet ist. Somit muss keine separate Schalteinheit vorgesehen sein. Es wird die vorhandener Verformungsmesseinheit verwendet, welche ein einziges Bauteil mit Verformungssensor und Schaltern darstellt.

Vorzugsweise handelt es sich bei dem Behältnis um einen Schrank oder ein Haushaltsgerät, insbesondere ein vollintegriertes Küchengerät. Das erste Element kann ein Korpus und das zweite Element ein gegenüber dem Korpus bewegbar gehaltenes Element, insbesondere ein Deckel, eine Klappe, ein Auszug oder eine Tür sein.

Bei dem Verformungssensor handelt es sich vorzugsweise um einen Sensor zur Aufnahme einer relativen Verformungsänderung, insbesondere ein Piezoelement mit einem Piezokristall, oder einen Dehnungsmessstreifen. Piezoelemente und Dehnungsmessstreifen haben den Vorteil, dass sie Verformungssignale ermöglichen, die bereits bei Verformungen ausgewertet werden können, die von einem Benutzer nicht wahrgenommen werden.

Das zweite Element ist über die Verformungsmesseinheit gegen das erste Element abgestützt. Die Verformungsmesseinheit kann zum Beispiel an einem ersten Element in Form eins Möbelkorpus angeordnet sein, wobei sich das zweite Element, zum Beispiel in Form einer Klappe oder eines Deckels, gegen die Verformungsmesseinheit abstützt. Die Verformungsmesseinheit kann derart in eine Seitenwand des Korpus eingelassen sein, dass der Verformungssensor geringfügig über eine Vorderkante der Seitenwand vorsteht, so dass die Klappe in Anlage zu dem Verformungssensor gelangen kann. Hierbei kann die Klappe in der Schließstellung die Verformungsmesseinheit vollständig abdecken, so dass sie für den Benutzer nicht sichtbar ist. Durch eine Kraftausübung von außen auf die Klappe in Richtung zum Möbelkorpus und somit auf den Verformungssensor wird das dadurch entstandene Verformungssignal geändert, wodurch ein Betätigen der Antriebsvorrichtung ausgelöst werden kann. Insbesondere, wenn es sich bei dem Verformungssensor um ein Piezoelement mit einem Piezokristall handelt, ist der erforderliche Weg bzw. die erforderliche Verformung derart gering, dass diese vom Benutzer nicht wahrgenommen wird, was zu einem angenehm haptischen Gefühl beim Betätigen der Klappe bzw. der Antriebsvorrichtung führt. Darüber hinaus lässt sich eine solche Verformungsmesseinheit auch bei Behältnissen einsetzen, bei denen zwischen dem Möbelkorpus und der Klappe bzw. dem ersten Element und dem zweiten Element Dichtelemente vorgesehen sind, die nur um einen sehr geringen Betrag verformt werden müssen, um die Antriebsvorrichtung zu betätigen.

Ferner wird die Aufgabe durch ein Verfahren zum Auslösen einer Antriebsvorrichtung eines Behältnisses nach einer der vorangehenden Art gelöst, wobei der Verlauf der relativen Verformungsänderung anhand des Verformungssignals ausgewertet wird und bei Erfüllen vorbestimmter Bedingungen die Antriebsvorrichtung betätigt wird. Hierbei wird das Verformungssignal vorzugsweise derart ausgewertet, dass ein unbeabsichtigtes Betätigen der Antriebsvorrichtung verhindert wird. Je nach Art der Kraftausübung ergibt sich ein bestimmter Verlauf des Verformungssignals, wobei anhand des Verlaufs des Verformungssignals zwischen unterschiedlichen Krafteinwirkungen unterschieden werden kann. So ist beispielsweise die Kraftausübung auf die Verformungsmesseinheit, auch zum Beispiel über das zweite Element, bei einer schaltenden Bewegung einer Person deutlich von dem Verlauf des Verformungssignals unterscheidbar, welches bei einem unbeabsichtigten Schlagen oder Anlehnen gegen das zweite Element entsteht.

Bevorzugte Ausführungsbeispiele werden im Folgenden anhand der Figuren näher erläutert und hierin zeigen:
- Figur 1: eine perspektivische Darstellung eines Schranks mit einem Korpus und einem Deckel in seiner Schließstellung;
- Figur 2: einen Schrank gemäß Figur 1 mit dem Deckel in seiner Offenstellung;
- Figur 3: eine perspektivische Darstellung einer Verformungsmesseinheit gemäß der Figuren 1 und 2;
- Figur 4: eine Innenansicht des Schranks mit der Verformungsmesseinheit gemäß Figur 3;

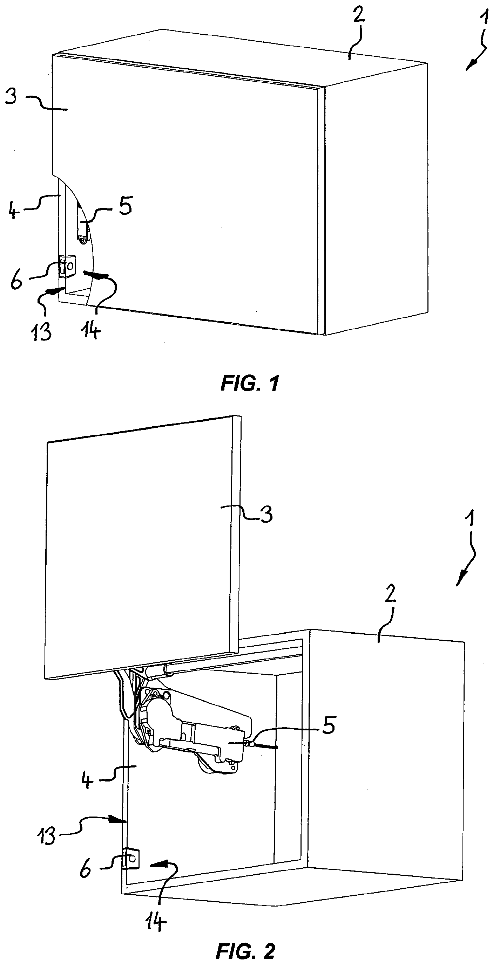

Die Figuren 1 und 2 zeigen eine Ausführungsform eines erfindungsgemäßen Behälters, wobei der Behälter als Schrank 1 gestaltet ist und ein erstes Element in Form eines Korpus 2 und ein zweites Element in Form eines Deckels 3 umfasst. Der Deckel 3 ist über eine Antriebsvorrichtung 5 in Form von Deckelstellern mit dem Korpus 2 verbunden und kann relativ zum Korpus 2 aus der in Figur 1 dargestellten Schließstellung in die in Figur 2 dargestellte Offenstellung bewegt werden. Die Antriebsvorrichtung 5 umfasst hierbei einen elektrischen Antrieb (z.B. einen Elektromotor), der ein automatisches Verstellen des Deckels 3 ermöglicht.

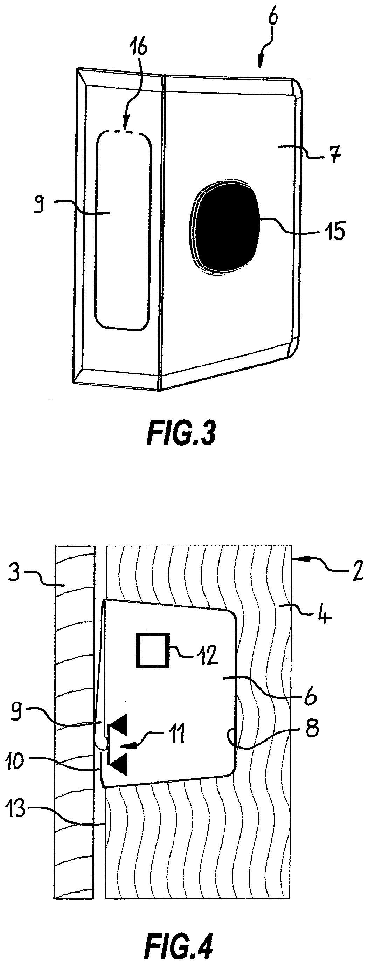

Der Korpus 2 umfasst unter anderem eine Seitenwand 4, in die eine Verformungsmesseinheit 6 eingelassen ist. Die Verformungsmesseinheit 6 ist in den Figuren 3 und 4 detailliert dargestellt. Figur 4 zeigt einen Teilquerschnitt durch den Schrank 1 gemäß Figur 1 mit dem Deckel 3 in seiner Schließstellung. Die Verformungsmesseinheit 6 ist ferner schematisch im Längsschnitt dargestellt.

Die Verformungsmesseinheit 6 umfasst ein Aufnahmeelement in Form eines Gehäuses 7. Das Gehäuse 7 ist in eine Ausnehmung 8 der Seitenwand 4 eingelassen. Die Ausnehmung 8 geht sowohl von einer Stirnfläche 13 als auch von einer Innenfläche 14 der Seitenwand 4 aus. Die Stirnfläche 13 ist zum Deckel 3 hin gerichtet, wobei der Deckel 3 die Stirnfläche 13 in der Schließstellung überdeckt. Die Verformungsmesseinheit 6 umfasst einen Tastarm 9, der im vorliegenden Beispiel einstückig mit dem Gehäuse 7 ausgebildet ist und verformbar zu diesem angeordnet ist. Vorzugsweise ist das Gehäuse 7 aus einem Kunststoff gefertigt, so dass der Tastarm 9 über ein Filmscharnier 16 mit dem Gehäuse 7 verbunden ist und elastisch bewegbar ist. Hierbei steht der Tastarm 9 über eine Frontfläche 10 des Gehäuses 7 und über die Stirnfläche 13 der Seitenwand 4 vor. Der Deckel 3 ist, wie in Figur 4 ersichtlich, in seiner Schließstellung über den Tastarm 9 gegen die Verformungsmesseinheit 6 und somit indirekt gegen den Korpus 2 abgestützt.

Im Inneren des Gehäuses 7 befindet sich ein Piezoelement 11, welches in Figur 4 schematisch dargestellt ist. Durch Ausübung einer Kraft auf den Tastarm 9 in Richtung des Piezoelements 11 wird somit eine Kraft auf das Piezoelement 11, welches ein Piezokristall umfasst, ausgeübt, so dass ein Verformungssignal vom Piezoelement 11 erzeugt wird. Das Verformungssignal wird weitergeleitet an eine Steuereinheit 12, die entweder Bestandteil der Verformungsmesseinheit 6 ist oder als separates Element vorgesehen ist, welches über eine herkömmliche Datenverbindung, zum Beispiel Funk- oder Kabelverbindung, mit der Verformungsmesseinheit 6 verbunden ist. Die Steuereinheit 12 ist ferner über herkömmliche Datenverbindungen mit der Antriebsvorrichtung 5 verbunden, so dass bei einer Kraftausübung vom Deckel 3 über den Tastarm 9 auf das Piezoelement 11 ein Betätigen der Antriebsvorrichtung 5 möglich ist.

Auf derjenigen Seite der Verformungsmesseinheit 6, welche an der Innenfläche 14 der Seitenwand 4 aus der Ausnehmung 8 herausragt, ist ein separater Schalter 15 vorgesehen. Der Schalter 15 kann manuell bedient werden, so dass bei geöffnetem Deckel 3 über den leicht zu erreichenden Schalter 15 der Deckel 3 von seiner Offenstellung wieder in seine Schließstellung überführt werden kann. Hierzu ist der Schalter 15 ebenfalls mit der Steuereinheit 12 über eine Datenverbindung verbunden.

### Bezugszeichenliste

- 1: Schrank
- 2: Korpus
- 3: Deckel
- 4: Seitenwand
- 5: Antriebsvorrichtung
- 6: Verformungsmesseinheit
- 7: Gehäuse
- 8: Ausnehmung
- 9: Tastarm
- 10: Frontfläche
- 11: Piezoelement
- 12: Steuereinheit
- 13: Stirnfläche
- 14: Innenfläche
- 15: Schalter
- 16: Filmscharnier

## Patentansprüche

1. Behältnis (1) umfassend
ein erstes Element (2) und zumindest ein zum ersten Element (2) zwischen einer Schließstellung und einer Offenstellung bewegbares zweites Element (3),
eine Antriebsvorrichtung (5) zum Bewegen des zweiten Elements (3), **dadurch gekennzeichnet,**
**dass** das Behältnis zumindest eine Verformungsmesseinheit (6) mit einem Verformungssensor (11) an zumindest einem der Elemente (2, 3) zum Aufnehmen einer auf eines der Elemente (2, 3) ausgeübten Kraft, und
eine Steuereinheit (12) zum Empfangen und Auswerten eines von der Verformungsmesseinheit (6) übermittelten Verformungssignals und zum Betätigen der Antriebsvorrichtung (5) aufweist,
wobei die Verformungsmesseinheit (6) ein Aufnahmeelement (7) aufweist, in dem der Verformungssensor (11) aufgenommen ist,
wobei das Aufnahmeelement (7) in oder an dem ersten Element (2) befestigt ist,
wobei das zweite Element (3) gegen den Verformungssensor (11) abgestützt ist, und
wobei in dem Aufnahmeelement (7) ein zusätzlicher Schalter (15) zum Betätigen der Antriebsvorrichtung (5) integriert ist.

2. Behältnis nach Anspruch 1,
**dadurch gekennzeichnet,**
**dass** das Behältnis ein Schrank (1) oder ein Haushaltsgerät, insbesondere ein vollintegriertes Küchengerät, ist,
**dass** das erste Element ein Korpus (2) ist und
**dass** das zweite Element ein gegenüber dem Korpus (2) bewegbar gehaltenes Element ist.

3. Behältnis nach einem der vorangehenden Ansprüche,
**dadurch gekennzeichnet,**
**dass** der Verformungssensor (11) ein Sensor zur Aufnahme einer relativen Verformungsänderung ist und insbesondere ein Piezoelement (11) oder einen Dehnungsmessstreifen umfasst.

4. Behältnis nach einem der vorangehenden Ansprüche,
**dadurch gekennzeichnet,**
**dass** das zweite Element (3) über die Verformungsmesseinheit (6) gegen das erste Element (2) abgestützt ist.

5. Verfahren zum Auslösen einer Antriebsvorrichtung eines Behältnisses nach einem der vorangehenden Ansprüche,
**dadurch gekennzeichnet,**
**dass** der Verlauf der relativen Verformungsänderung anhand des Verformungssignals ausgewertet wird und bei Erfüllen vorbestimmter Bedingungen die Antriebsvorrichtung (5) betätigt wird.

## Claims

1. Container (1) comprising
a first element (2) and at least one second element (3) movable relative to the first element (2) between a closed position and an open position, and
a drive device (5) for moving the second element (3),
**characterized in**
**that** the container comprises at least one deformation measuring unit (6) with a deformation sensor (11) on at least one of the elements (2, 3) for detecting a force exerted on one of the elements (2, 3) and
a control unit (12) for receiving and evaluating a deformation signal transmitted by the deformation measuring unit (6) and for actuating the drive device (5),
wherein the deformation measuring unit (6) comprises an accommodation element (7) accommodating the deformation sensor (11),
wherein the accommodation element (7) is mounted in or on the first element (2),
wherein the second element (3) is supported against the deformation sensor (11), and
wherein an additional switch (15) for actuating the drive device (5) is integrated into the accommodation element (7).

2. Container according to claim 1,
**characterized in**
**that** the container is a cabinet (1) or a household appliance, especially a fully integrated kitchen appliance,
**that** the first element is a carcass (2) and
**that** the second element is an element, movably held relative to the carcass (2).

3. Container according to one of the preceding claims,
**characterized in**
**that** the deformation sensor (11) is a sensor for recording a relative deformation change and comprises especially a piezo element (11) or a strain gauge.

4. Container according to one of the preceding claims,
**characterized in**
**that** the second element (3) is supported via the deformation measuring unit (6) against the first element (2).

5. Method for actuating a drive device of a container according to one of the preceding claims,
**characterized in**
**that** the course of the relative deformation change is evaluated by using the deformation signal and, when fulfilling predetermined conditions, the drive device (5) is actuated.

## Revendications

1. Récipient (1) comprenant
un premier élément (2) et au moins un deuxième élément (3) mobile vers le premier élément (2) entre une position de fermeture et une position d'ouverture,
un dispositif actionneur (5) pour déplacer le deuxième élément (3),
**caractérisé en ce que**
le récipient comporte au moins une unité de déformation (6) avec un capteur de déformation (11) sur au moins un des éléments (2, 3) pour réceptionner une force exercée sur un des éléments (2, 3) et une unité de commande (12) pour recevoir et évaluer un signal de déformation transmis par l'unité de déformation (6) et pour actionner le dispositif actionneur (5),
sachant que l'unité de déformation (6) comporte un élément de logement (7) dans lequel est logé le capteur de déformation (11),
sachant que l'élément de logement (7) est fixé dans ou sur le premier élément (2),
sachant que le deuxième élément (3) est appuyé contre le capteur de déformation (11) et
sachant que dans l'élément de logement (7) est intégré un interrupteur (15) supplémentaire pour actionner le dispositif actionneur (5).

2. Récipient selon la revendication 1,
**caractérisé en ce que**
le récipient est une armoire (1) ou un appareil ménager, en particulier un appareil de cuisine complètement intégré,
**en ce que** le premier élément est un corps (2) et
**en ce que** le deuxième élément est un élément maintenu mobile par rapport au corps (2).

3. Récipient selon l'une quelconque des revendications précédentes,
**caractérisé en ce que**
le capteur de déformation (11) est un capteur pour réceptionner une modification de déformation relative et comprend en particulier un élément piézoélectrique (11) ou un extensomètre.

4. Récipient selon l'une quelconque des revendications précédentes,
**caractérisé en ce que**
le deuxième élément (3) est appuyé par le biais de l'unité de déformation (6) contre le premier élément (2) .

5. Procédé pour déclencher un actionneur d'un récipient selon l'une quelconque des revendications précédentes,
**caractérisé en ce que**
le profil de la modification de déformation relative est évalué à l'aide du signal de déformation et l'actionneur (5) est actionné en remplissant des conditions prédéterminées.
